# EUROPEAN PATENT APPLICATION

(11) **EP 3 591 726 A1**
(43) Date of publication of application: **08.01.2020**
(21) Application number: 18761463.1
(22) Date of filing: 02.03.2018
(51) Int. Cl.: H01L 51/48, H01L 51/44

(54) **SOLAR CELL AND METHOD FOR MANUFACTURING SOLAR CELL**

(30) Priority: 02.03.2017 JP 2017039372; 07.03.2017 JP 2017042876
(71) Applicant: Sekisui Chemical Co., Ltd., Osaka-shi, Osaka 530-0047 (JP)
(72) Inventor: AITA, Tetsuya, Mishima-gun Osaka 618-0021 (JP); HAYAKAWA, Akinobu, Mishima-gun Osaka 618-0021 (JP); ASANO, Motohiko, Mishima-gun Osaka 618-0021 (JP); YUKAWA, Mayumi, Mishima-gun Osaka 618-0021 (JP); UNO, Tomohito, Mishima-gun Osaka 618-0021 (JP); KUREBAYASHI, Tetsuya, Mishima-gun Osaka 618-0021 (JP); MORITA, Takeharu, Mishima-gun Osaka 618-0021 (JP)
(74) Representative: Cabinet Beau de Loménie
(86) International application number: PCT/JP2018/007957
(87) International publication number: WO 2018/159799

(57) **Abstract**

A first object of the present invention is to provide a solar cell having excellent photoelectric conversion efficiency and produced through a process including favorable scribing (e.g., mechanical patterning), and a method for producing the solar cell. A first aspect of the present invention provides a solar cell including, above a flexible substrate, an electrode, a transparent electrode, and a photoelectric conversion layer disposed between the electrode and the transparent electrode, the solar cell further including a hard film disposed between the flexible substrate and the electrode, the hard film containing a nitride, carbide, or boride, the nitride, carbide, or boride containing at least one element selected from the group consisting of titanium, zirconium, aluminum, silicon, magnesium, vanadium, chromium, molybdenum, tantalum, and tungsten.

## Description

### TECHNICAL FIELD

The present invention relates to a solar cell having excellent photoelectric conversion efficiency and produced through a process including favorable scribing (e.g., mechanical patterning), and a method for producing the solar cell. The present invention also relates to a solar cell having low series resistance and high photoelectric conversion efficiency.

### BACKGROUND ART

Laminates having an N-type semiconductor layer and a P-type semiconductor layer disposed between opposing electrodes have been conventionally actively developed as solar cells. The N-type and P-type semiconductors mainly used are inorganic semiconductors such as silicon. Such inorganic solar cells, however, are utilized only in a limited range because their production is costly and upsizing thereof is difficult.

Recently, perovskite solar cells have received attention which include, in a photoelectric conversion layer thereof, an organic-inorganic perovskite compound having a perovskite structure containing lead, tin, or the like as a central metal (see Patent Literature 1 and Non-Patent Literature 1, for example). Perovskite solar cells are expected to achieve high photoelectric conversion efficiency and can be produced by a printing method. Thus, the production cost thereof can be greatly reduced.

On the other hand, flexible solar cells have recently been receiving attention which include, as a substrate, a polyimide- or polyester-based heat-resistant polymer material or metal foil. Flexible solar cells have advantages such as easy transport and working owing to thinning and weight reduction thereof, and shock resistance. For example, a flexible solar cell is produced by stacking, on a flexible substrate, a plurality of thin-film layers such as a photoelectric conversion layer that has a function of generating current when irradiated with light. If necessary, a solar cell sealing sheet is stacked on each of the upper and lower surfaces of the flexible solar cell to seal the flexible solar cell.

For example, Patent Literature 2 discloses a substrate for a semiconductor device including a sheet-like aluminum substrate, and an organic thin-film solar cell including this substrate for a semiconductor device.

### CITATION LIST

### - Patent Literature

Patent Literature 1: JP 2014-72327 A
Patent Literature 2: JP 2013-253317 A

### - Non-Patent Literature

Non-Patent Literature 1: M. M. Lee, et al, Science, 2012, 338, 643

### SUMMARY OF INVENTION

### - Technical Problem

A first object of the present invention is to provide a solar cell having excellent photoelectric conversion efficiency and produced through a process including favorable scribing (e.g., mechanical patterning), and a method for producing the solar cell. A second object of the present invention is to provide a solar cell having low series resistance and high photoelectric conversion efficiency.

### - Solution to Problem

The present invention relates to a solar cell (hereinafter, also referred to as a first aspect of the present invention) including, above a flexible substrate, an electrode, a transparent electrode, and a photoelectric conversion layer disposed between the electrode and the transparent electrode, the solar cell further including a hard film disposed between the flexible substrate and the electrode, the hard film containing a nitride, carbide, or boride, the nitride, carbide, or boride containing at least one element selected from the group consisting of titanium, zirconium, aluminum, silicon, magnesium, vanadium, chromium, molybdenum, tantalum, and tungsten.

The present invention also relates to a solar cell (hereinafter, also referred to as a second aspect of the present invention) including, in the stated order, a cathode, an electron transport layer, a photoelectric conversion layer, and an anode, the photoelectric conversion layer containing an organic-inorganic perovskite compound represented by the formula: R-M-X₃, wherein R represents an organic molecule; M represents a metal atom; and X represents a halogen atom or a chalcogen atom, the cathode containing a metal having a lower ionization tendency than titanium.

The present invention is specifically described in the following.

First, the first aspect of the present invention is described. In common production of a solar cell including, above a flexible substrate, an electrode, a transparent electrode, and a photoelectric conversion layer disposed between the electrode and the transparent electrode, an electrode is formed on a flexible substrate and the electrode formed is partly scribed by a physical method such as mechanical patterning using a scribing tool, for example. In this process, the load applied to the scribing tool is transmitted to the edge of the scribing tool. Thereby, the portion of the electrode in contact with the edge is scribed, peeled, and removed.

The present inventors have newly found that in such scribing, the edge of the scribing tool comes into contact with the flexible substrate placed below the electrode to intrude into the flexible substrate or to generate a recess in the flexible substrate, thereby causing product failure. Although the scribing depth can be controlled by changing the load applied to the scribing tool, this load may be unstable and vary in mass production. Thus, it is difficult to sufficiently reduce intrusion of the edge into the flexible substrate and generation of a recess in the flexible substrate.

Then, in production of a solar cell, a photoelectric conversion layer is formed on the scribed electrode and the photoelectric conversion layer formed is partly scribed, and further a transparent electrode is formed on the scribed photoelectric conversion layer and the transparent electrode formed is partly scribed. Stacking a plurality of patterned layers above the flexible substrate as described is a common method.

The present inventors examined a solar cell including, above a flexible substrate, an electrode, a transparent electrode, and a photoelectric conversion layer disposed between the electrode and the transparent electrode. The present inventors then found that further disposing a specific hard film between the flexible substrate and the electrode in such a solar cell enables favorable scribing (e.g., mechanical patterning) while reducing intrusion of the edge into the flexible substrate and generation of a recess in the flexible substrate, providing a solar cell having excellent photoelectric conversion efficiency. Thereby, the first aspect of the present invention was completed.

The solar cell of the first aspect of the present invention includes, above a flexible substrate, an electrode, a transparent electrode, and a photoelectric conversion layer disposed between the electrode and the transparent electrode.

The term "layer" as used herein means not only a layer having a clear boundary, but also a layer having a concentration gradient in which contained elements are gradually changed. The elemental analysis of the layer can be performed, for example, by FE-TEM/EDS analysis of a cross section of the solar cell to confirm the element distribution of a particular element. Also, the term "layer" as used herein means not only a flat thin-film layer, but also a layer capable of forming an intricate structure together with other layer(s).

The flexible substrate may be any one, and examples thereof include resin films formed from a polyimide- or polyester-based heat-resistant polymer, metal foil, and thin plate glass. In particular, metal foil is preferred.

The use of metal foil can reduce the cost and enables high-temperature treatment in comparison with the case of using a heat-resistant polymer. In other words, even when thermal annealing (heating treatment) at a temperature of 80°C or higher is performed for the purpose of imparting light resistance (resistance to photo-deterioration) in formation of a photoelectric conversion layer containing an organic-inorganic perovskite compound, occurrence of distortion can be minimized and high photoelectric conversion efficiency can be achieved.

The metal foil may be any one, and examples thereof include a metal foil formed of a metal such as aluminum, titanium, copper, or gold, and a metal foil formed of an alloy such as stainless steel (SUS). These may be used alone or in combination of two or more. In particular, aluminum foil is preferred. The use of aluminum foil can reduce the cost and can improve the workability owing to its flexibility in comparison with the case of using other metal foil.

The flexible substrate may further include an insulating layer formed on the metal foil. In other words, the flexible substrate may be one including a metal foil and an insulating layer formed on the metal foil.

The insulating layer may be any one, and examples thereof include inorganic insulating layers formed from aluminum oxide, silicon oxide, zinc oxide, or the like, and organic insulating layers formed from epoxy resin, polyimide, or the like. In particular, when the metal foil is an aluminum foil, the insulating layer is preferably an aluminum oxide film.

The use of the aluminum oxide film as the insulating layer can reduce deterioration of the photoelectric conversion layer (especially, a photoelectric conversion layer containing an organic-inorganic perovskite compound) due to permeation of moisture in the air through the insulating layer in comparison with the case of an organic insulating layer. The use of the aluminum oxide film as the insulating layer can also reduce a phenomenon in which the photoelectric conversion layer containing an organic-inorganic perovskite compound is discolored over time as a result of contact with the aluminum foil and corrosion occurs.

For other common solar cells, no report has been made on discoloration of a photoelectric conversion layer due to a reaction with aluminum. The above phenomenon of corrosion occurrence is a problem characteristic of a perovskite solar cell in which the photoelectric conversion layer contains an organic-inorganic perovskite compound. This problem is found by the present inventors.

The aluminum oxide film may have any thickness. The lower limit of the thickness is preferably 0.1 µm and the upper limit thereof is preferably 20 µm. The lower limit is more preferably 0.5 µm and the upper limit is more preferably 10 µm. When the thickness of the aluminum oxide film is 0.5 µm or greater, the aluminum oxide film can sufficiently cover a surface of the aluminum foil, leading to stable insulation between the aluminum foil and the electrode. When the thickness of the aluminum oxide film is 10 µm or smaller, a crack is less likely to be generated in the aluminum oxide film even when the flexible substrate is bent. Further, in the heating treatment in formation of a photoelectric conversion layer containing an organic-inorganic perovskite compound, generation of a crack can be reduced in the aluminum oxide film and/or the layer formed thereon due to difference in coefficient of thermal expansion from the aluminum foil.

The thickness of the aluminum oxide film can be measured by, for example, observing a cross section of the flexible substrate using an electron microscope (e.g., S-4800 available from Hitachi Ltd.) and analyzing the contrast of the picture taken.

The proportion of the thickness of the aluminum oxide film to the thickness of the flexible substrate, which is taken as 100%, may be any value. The lower limit of the proportion is preferably 0.1% and the upper limit thereof is preferably 15%, the lower limit is more preferably 0.5% and the upper limit is more preferably 5%.

It may be considered to increase the thickness of the aluminum oxide film to reduce intrusion of the edge into the aluminum foil and generation of a recess in the aluminum foil, thereby reducing occurrence of product failure. Still, to reduce occurrence of such product failure by increasing the thickness of the aluminum oxide film is difficult for the following reasons.

That is, the aluminum oxide film has a lower hardness than the hard film to be described later. Thus, in order to reduce intrusion of the edge into the aluminum foil and generation of a recess in the aluminum foil, the thickness needs to be greatly increased. Nevertheless, such a great increase in the thickness causes a harmful effect of easy crack generation in the aluminum oxide film.

The aluminum oxide film commonly has a Vickers hardness of about 300 HV.

The aluminum oxide film may be formed by any method. Examples of the method include a method of anodizing the aluminum foil, a method of applying an alkoxide of aluminum, for example, on a surface of the aluminum foil, and a method of forming a natural oxide film on a surface of the aluminum foil by heat treatment. In particular, the method of anodizing the aluminum foil is preferred because this method can uniformly oxidize the whole surface of the aluminum foil and thus is suitable for mass production. In other words, the aluminum oxide film is preferably an anodic oxide film.

In the case of anodizing the aluminum foil, the thickness of the aluminum oxide film can be adjusted by changing the treatment concentration, treatment temperature, current density, treatment duration, and the like in the anodizing. The treatment duration may be any value. From the viewpoint of easy production of the flexible substrate, the lower limit thereof is preferably 5 minutes and the upper limit thereof is preferably 120 minutes, the upper limit is more preferably 60 minutes.

The flexible substrate may have any thickness. The lower limit of the thickness is preferably 5 µm and the upper limit thereof is preferably 500 µm. When the thickness of the flexible substrate is 5 µm or greater, the resulting solar cell can have sufficient mechanical strength and excellent handleability. When the thickness of the flexible substrate is 500 µm or smaller, the resulting solar cell can have excellent flexibility. The lower limit of the thickness of the flexible substrate is more preferably 10 µm and the upper limit thereof is more preferably 100 µm.

When the flexible substrate includes the metal foil and an insulating layer formed on the metal foil, the thickness of the flexible substrate means the thickness of the whole flexible substrate including the metal foil and the insulating layer.

When the flexible substrate includes the metal foil and an insulating layer formed on the metal foil as described above, the electrode is disposed on the insulating layer side of the flexible substrate.

Either of the electrode and the transparent electrode may be a cathode, and either of them may be an anode. Examples of the materials of the electrode and the transparent electrode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, and metals such as gold. The examples also include transparent conductive materials such as CuI, ITO (indium tin oxide), SnO₂, aluminum zinc oxide (AZO), indium zinc oxide (IZO), and gallium zinc oxide (GZO), and transparent conductive polymers. These materials may be used alone or in combination of two or more.

The photoelectric conversion layer preferably contains an organic-inorganic perovskite compound represented by the formula: R-M-X₃, wherein R represents an organic molecule; M represents a metal atom; and X represents a halogen atom or a chalcogen atom.

The use of the organic-inorganic perovskite compound in the photoelectric conversion layer can improve the photoelectric conversion efficiency of the solar cell.

R is an organic molecule and is preferably represented by CₗNₘHₙ (l, m, and n each represent a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, imidazoline, carbazole, methyl carboxy amine, ethyl carboxy amine, propyl carboxy amine, butyl carboxy amine, pentyl carboxy amine, hexyl carboxy amine, formamidinium, guanidine, aniline, pyridine, and ions thereof, and phenethyl ammonium. An exemplary ion is methyl ammonium (CH₃NH₃). In particular, methylamine, ethylamine, propylamine, propyl carboxy amine, butyl carboxy amine, pentyl carboxy amine, formamidinium, guanidine, and ions thereof are preferred, and methylamine, ethylamine, pentyl carboxy amine, formamidinium, guanidine, and ions thereof are more preferred. In particular, methylamine, formamidinium, and ions thereof are still more preferred because they can lead to high photoelectric conversion efficiency.

M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. From the viewpoint of electron orbital overlap, lead or tin is preferred. These metal atoms may be used alone or in combination of two or more.

X represents a halogen atom or a chalcogen atom. Examples thereof include chlorine, bromine, iodine, sulfur, and selenium. These halogen atoms and chalcogen atoms may be used alone or in combination of two or more. In particular, a halogen atom is preferred because the organic-inorganic perovskite compound containing halogen in the structure can be soluble in an organic solvent and can be used in an inexpensive printing method or the like. In addition, iodine is more preferred because the organic-inorganic perovskite compound can have a narrower energy band gap.

The organic-inorganic perovskite compound preferably has a cubic crystal structure where the metal atom M is placed at the body center, the organic molecule R is placed at each vertex, and the halogen or chalcogen atom X is placed at each face center.

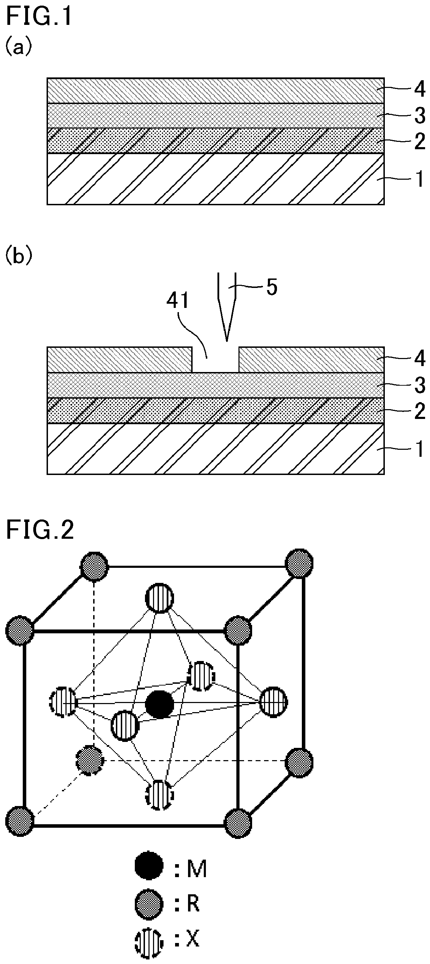

Fig. 2 is a schematic view of an exemplary crystal structure of the organic-inorganic perovskite compound having a cubic crystal structure where the metal atom M is placed at the body center, the organic molecule R is placed at each vertex, and the halogen or chalcogen atom X is placed at each face center. Although the details are not clear, it is presumed that this structure allows the octahedron in the crystal lattice to change its orientation easily, which enhances the mobility of electrons in the organic-inorganic perovskite compound, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution.

When the organic-inorganic perovskite compound is a crystalline semiconductor, the mobility of electrons in the organic-inorganic perovskite compound is enhanced, improving the photoelectric conversion efficiency of the solar cell. When the organic-inorganic perovskite compound is a crystalline semiconductor, a reduction in photoelectric conversion efficiency (photodegradation) due to continuous irradiation of the solar cell with light, especially photodegradation caused by a reduction in short-circuit current can be easily reduced.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by a fitting technique, determining the respective intensity integrals, and calculating the proportion of the crystalline portion to the whole.

The lower limit of the degree of crystallinity of the organic-inorganic perovskite compound is preferably 30%. When the degree of crystallinity is 30% or higher, the mobility of electrons in the organic-inorganic perovskite compound is enhanced, improving the photoelectric conversion efficiency of the solar cell. When the degree of crystallinity is 30% or higher, a reduction in photoelectric conversion efficiency (photodegradation) due to continuous irradiation of the solar cell with light, especially photodegradation caused by a reduction in short-circuit current can be easily reduced. The lower limit of the degree of crystallinity is more preferably 50%, still more preferably 70%.

Examples of the method for increasing the degree of crystallinity of the organic-inorganic perovskite compound include thermal annealing (heating treatment), irradiation with strong-intensity light, such as laser, and plasma irradiation.

The crystallite diameter may also be evaluated as another index of crystallization. The crystallite diameter can be calculated from the half width of a crystalline substance-derived scattering peak, which is detected by X-ray scattering intensity distribution measurement, by the Halder-Wagner method.

When the crystallite diameter of the organic-inorganic perovskite compound is 5 nm or greater, a reduction in photoelectric conversion efficiency (photodegradation) due to continuous irradiation of the solar cell with light, especially photodegradation caused by a reduction in short-circuit current can be reduced. The mobility of electrons in the organic-inorganic perovskite compound is enhanced and the photoelectric conversion efficiency of the solar cell is improved. The lower limit of the crystallite diameter is more preferably 10 nm, and the lower limit thereof is still more preferably 20 nm.

The photoelectric conversion layer may further contain an organic semiconductor or an inorganic semiconductor, in addition to the organic-inorganic perovskite compound, as long as the effects of the present invention are not impaired. The organic semiconductor or inorganic semiconductor herein may serve as a hole transport layer or an electron transport layer.

Examples of the organic semiconductor include compounds having a thiophene skeleton, such as poly(3-alkylthiophene). The examples also include conductive polymers having a poly-p-phenylenevinylene skeleton, a polyvinylcarbazole skeleton, a polyaniline skeleton, a polyacetylene skeleton, or the like. The examples further include: compounds having a phthalocyanine skeleton, a naphthalocyanine skeleton, a pentacene skeleton, and a porphyrin skeleton such as a benzoporphyrin skeleton, a spirobifluorene skeleton, or the like; and carbon-containing materials such as carbon nanotube, graphene, and fullerene, each of which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂, and Cu₂S.

The photoelectric conversion layer containing the organic-inorganic perovskite compound and the organic semiconductor or inorganic semiconductor may be a laminate in which a thin-film organic semiconductor or inorganic semiconductor part and a thin-film organic-inorganic perovskite compound part are stacked, or may be a composite film in which an organic semiconductor or inorganic semiconductor part and an organic-inorganic perovskite compound part are combined. The laminate is preferred from the viewpoint of a simple production process. The composite film is preferred from the viewpoint of improvement in charge separation efficiency in the organic semiconductor or the inorganic semiconductor.

The lower limit of the thickness of the thin-film organic-inorganic perovskite compound part is preferably 5 nm and the upper limit thereof is preferably 5,000 nm. When the thickness is 5 nm or greater, the thin-film organic-inorganic perovskite compound part can sufficiently absorb light, enhancing the photoelectric conversion efficiency. When the thickness is 5,000 nm or smaller, formation of a region which fails to achieve charge separation can be reduced, improving the photoelectric conversion efficiency. The lower limit of the thickness is more preferably 10 nm and the upper limit thereof is more preferably 1,000 nm. The lower limit of the thickness is still more preferably 20 nm and the upper limit thereof is still more preferably 500 nm.

When the photoelectric conversion layer is a composite film in which an organic semiconductor or inorganic semiconductor part and an organic-inorganic perovskite compound part are combined, the lower limit of the thickness of the composite film is preferably 30 nm and the upper limit thereof is preferably 3,000 nm. When the thickness is 30 nm or greater, the composite film can sufficiently absorb light, enhancing the photoelectric conversion efficiency. When the thickness is 3,000 nm or smaller, charges are likely to reach the electrode, enhancing the photoelectric conversion efficiency. The lower limit of the thickness is more preferably 40 nm and the upper limit thereof is more preferably 2,000 nm. The lower limit is still more preferably 50 nm and the upper limit is still more preferably 1,000 nm.

The photoelectric conversion layer is preferably subjected to thermal annealing (heating treatment) after formation of the photoelectric conversion layer. Performing thermal annealing (heating treatment) can sufficiently increase the degree of crystallinity of the organic-inorganic perovskite compound in the photoelectric conversion layer and can further reduce a reduction in photoelectric conversion efficiency (photodegradation) due to continuous irradiation with light.

Performing such thermal annealing (heating treatment) on a solar cell including a resin film formed from a heat-resistant polymer may cause distortion in annealing due to a difference in coefficient of thermal expansion between the resin film and the photoelectric conversion layer and the like, resulting in a difficulty in achieving high photoelectric conversion efficiency. The use of the metal foil can minimize occurrence of distortion even when thermal annealing (heating treatment) is performed, leading to high photoelectric conversion efficiency.

In the case of performing the thermal annealing (heating treatment), the photoelectric conversion layer may be heated at any temperature. The temperature is preferably not lower than 100°C but lower than 250°C. When the heating temperature is not lower than 100°C, the degree of crystallinity of the organic-inorganic perovskite compound can be sufficiently increased. When the heating temperature is lower than 250°C, the heating treatment can be performed without thermal deterioration of the organic-inorganic perovskite compound. The heating temperature is more preferably 120°C or higher and 200°C or lower. The heating duration may also be any value, and is preferably three minutes or longer and two hours or shorter. When the heating duration is three minutes or longer, the degree of crystallinity of the organic-inorganic perovskite compound can be sufficiently increased. When the heating duration is two hours or shorter, the heating treatment can be performed without thermal deterioration of the organic-inorganic perovskite compound.

These heating operations are preferably performed in vacuum or inert gas. The dew point is preferably 10°C or lower, more preferably 7.5°C or lower, still more preferably 5°C or lower.

The photoelectric conversion layer may be formed by any method. Examples of the method include a vacuum evaporation method, a sputtering method, a chemical vapor deposition method (CVD), an electrochemical sedimentation method, and a printing method. In particular, the use of a printing method enables easy formation of a large-area solar cell that can exhibit high photoelectric conversion efficiency. Examples of the printing method include a spin coating method and a casting method. Examples of the method using the printing method include a roll-to-roll method.

The solar cell of the first aspect of the present invention further includes a hard film disposed between the flexible substrate and the electrode. The hard film contains a nitride, carbide, or boride, and the nitride, carbide, or boride contains at least one element selected from the group consisting of titanium, zirconium, aluminum, silicon, magnesium, vanadium, chromium, molybdenum, tantalum, and tungsten.

Disposing the hard film between the flexible substrate and the electrode enables favorable scribing (e.g., mechanical patterning) while reducing intrusion of the edge into the flexible substrate and generation of a recess in the flexible substrate. Thus, a solar cell having excellent photoelectric conversion efficiency can be obtained.

Fig. 1 includes schematic cross-sectional views illustrating an exemplary production process for the solar cell of the first aspect of the present invention. In the production process for the solar cell of the first aspect of the present invention illustrated in Fig. 1, a hard film 3 is formed on a flexible substrate including a metal foil 1 and an insulating layer 2 formed on the metal foil 1, and then an electrode 4 is formed on the hard film 3 formed (Fig. 1(a)). Next, the electrode 4 formed is partly scribed by mechanical patterning using a scribing tool 5. Thereby, the portion of the electrode 4 in contact with the edge is scribed, peeled, and removed and a groove 41 is formed (Fig. 1 (b)). Disposing the hard film 3 enables favorable scribing (e.g., mechanical patterning) while reducing intrusion of the edge into the flexible substrate including the metal foil 1 and the insulating layer 2 formed on the metal foil 1 and generation of a recess in the flexible substrate. Thus, a solar cell having excellent photoelectric conversion efficiency can be obtained.

The hard film contains a nitride, carbide, or boride, and the nitride, carbide, or boride contains at least one element selected from the group consisting of titanium, zirconium, aluminum, silicon, magnesium, vanadium, chromium, molybdenum, tantalum, and tungsten. These may be used alone or in combination of two or more. In particular, titanium nitride, titanium carbide, titanium boride, and molybdenum boride are preferred, titanium nitride, titanium carbide, and titanium boride are more preferred, and titanium nitride is particularly preferred because they have high hardness and enable easily formation of a hard film using a film-forming device used in the production process for the solar cell.

The lower limit of the Vickers hardness (HV) of the hard film is preferably 500 HV and the upper limit thereof is preferably 3,500 HV. When the Vickers hardness is 500 HV or higher, the hard film can sufficiently reduce intrusion of an edge into the flexible substrate and generation of a recess in the flexible substrate. When the Vickers hardness is 3,500 HV or lower, generation of a crack in the hard film can be reduced. The lower limit of the Vickers hardness is more preferably 700 HV and the upper limit thereof is more preferably 2,500 HV.

The Vickers hardness (HV) of the hard film can be measured by calculation from a load-displacement curve obtained by thrusting an indenter into the hard film formed on a glass substrate using Nano Indenter G200 (available from Keysight Technologies Inc.), for example.

The hard film may have any thickness. The lower limit of the thickness is preferably 30 nm and the upper limit thereof is preferably 5,000 nm. When the thickness of the hard film is 30 nm or greater, the hard film can sufficiently reduce intrusion of an edge into the flexible substrate and generation of a recess in the flexible substrate. When the thickness of the hard film is 5,000 nm or smaller, formation of the hard film may not take a long time and the productivity of the solar cell can be improved. The lower limit of the thickness of the hard film is more preferably 50 nm and the upper limit thereof is more preferably 1,000 nm.

The thickness of the hard film can be measured using a surface profiler P-16+ (available from KLA Tencor), for example.

The hard film may be formed by any method. For example, a vacuum dry film-forming method such as sputtering, ion plating, deposition, or CVD is preferred. In particular, sputtering is preferred. For example, in the case of forming a hard film containing titanium nitride (TiN), a TiN thin film can be formed by the use of Ti as the target for a magnetron sputtering technique and Ar and N₂ as the process gases.

The solar cell of the first aspect of the present invention may have an electron transport layer between the photoelectric conversion layer and either of the electrode and the transparent electrode serving as the cathode.

The electron transport layer may be formed from any material. Examples of the material include N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, (hydroxyquinolinato)aluminum, oxadiazole compounds, benzoimidazole compounds, naphthalenetetracarboxylic acid compounds, perylene derivatives, phosphine oxide compounds, phosphine sulfide compounds, and fluoro group-containing phthalocyanine. The examples further include titanium oxide, zinc oxide, indium oxide, tin oxide, gallium oxide, tin sulfide, indium sulfide, and zinc sulfide.

The electron transport layer may consist only of a thin-film electron transport layer (buffer layer). Preferably, the electron transport layer includes a porous electron transport layer. In particular, when the photoelectric conversion layer is a composite film in which an organic semiconductor or inorganic semiconductor part and an organic-inorganic perovskite compound part are combined, the composite film is preferably formed on a porous electron transport layer. This is because a more complicated composite film (more intricate structure) can be obtained, enhancing the photoelectric conversion efficiency.

The lower limit of the thickness of the electron transport layer is preferably 1 nm and the upper limit thereof is preferably 2,000 nm. When the thickness is 1 nm or greater, holes can be sufficiently blocked. When the thickness is 2,000 nm or smaller, the layer is less likely to serve as resistance to electron transport, enhancing the photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The solar cell of the first aspect of the present invention may have a hole transport layer between the photoelectric conversion layer and either of the electrode and the transparent electrode serving as the anode.

The hole transport layer may be formed from any material. Examples of the material include P-type conductive polymers, P-type low-molecular organic semiconductors, P-type metal oxides, P-type metal sulfides, and surfactants. Specific examples thereof include compounds having a thiophene skeleton, such as poly(3-alkylthiophene). The examples also include conductive polymers having a triphenylamine skeleton, a poly-p-phenylenevinylene skeleton, a polyvinylcarbazole skeleton, a polyaniline skeleton, a polyacetylene skeleton, or the like. The examples further include compounds having a phthalocyanine skeleton, a naphthalocyanine skeleton, a pentacene skeleton, a porphyrin skeleton such as a benzoporphyrin skeleton, a spirobifluorene skeleton, or the like. The examples furthermore include molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene.

The hole transport layer may partly merge with the photoelectric conversion layer or be disposed in the shape of a thin film on the photoelectric conversion layer. The lower limit of the thickness of the hole transport layer in the shape of a thin film is preferably 1 nm and the upper limit thereof is preferably 2,000 nm. When the thickness is 1 nm or greater, electrons can be sufficiently blocked. When the thickness is 2,000 nm or smaller, the layer is less likely to serve as resistance to electron transport, enhancing the photoelectric conversion efficiency. The lower limit of the thickness is more preferably 3 nm and the upper limit thereof is more preferably 1,000 nm. The lower limit is still more preferably 5 nm and the upper limit is still more preferably 500 nm.

The solar cell of the first aspect of the present invention has only to have the aforementioned structure. Further, preferably, the electrode, the photoelectric conversion layer, and the transparent electrode are each patterned to have a plurality of grooves, so that the solar cell is divided into a plurality of solar cell pieces. The solar cell pieces are preferably electrically connected to adjacent solar cell pieces.

The solar cell of the first aspect of the present invention may further include a barrier layer that seals the laminate including, above the flexible substrate, the electrode, the transparent electrode, and the photoelectric conversion layer disposed between the electrode and the transparent electrode, and further including the hard film disposed between the flexible substrate and the electrode.

The barrier layer may be formed from any material that exhibits barrier performance. Examples of the material include thermosetting resins, thermoplastic resins, and inorganic materials.

Examples of the thermosetting resins and the thermoplastic resins include epoxy resin, acrylic resin, silicone resin, phenol resin, melamine resin, and urea resin. The examples also include butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, and polyisobutylene.

When the material of the barrier layer is a thermosetting resin or a thermoplastic resin, the lower limit of the thickness of the barrier layer (resin layer) is preferably 100 nm and the upper limit thereof is preferably 100,000 nm. The lower limit of the thickness is more preferably 500 nm and the upper limit thereof is more preferably 50,000 nm, the lower limit is still more preferably 1,000 nm and the upper limit is still more preferably 20,000 nm.

Examples of the inorganic material include oxides, nitrides, and oxynitrides of Si, Al, Zn, Sn, In, Ti, Mg, Zr, Ni, Ta, W, Cu, and alloys containing two or more species thereof. In particular, in order to impart water vapor barrier performance and flexibility to the barrier layer, an oxide, a nitride, or an oxynitride of metal elements including both metal elements Zn and Sn is preferred.

When the material of the barrier layer is an inorganic material, the lower limit of the thickness of the barrier layer (inorganic layer) is preferably 30 nm and the upper limit thereof is preferably 3,000 nm. When the thickness is 30 nm or greater, the inorganic layer can exhibit sufficient water vapor barrier performance, improving the durability of the solar cell. When the thickness is 3,000 nm or smaller, the stress generated is low even when the thickness of the inorganic layer is increased, reducing separation of the inorganic layer and the laminate. The lower limit of the thickness is more preferably 50 nm and the upper limit thereof is more preferably 1,000 nm. The lower limit is still more preferably 100 nm and the upper limit is still more preferably 500 nm.

The thickness of the inorganic layer can be measured using an optical interference-type thickness meter (e.g., FE-3000 available from Otsuka Electronics Co., Ltd.).

Sealing of the laminate using the thermosetting resin or thermoplastic resin among the materials of the barrier layer may be achieved by any method. An exemplary method is to seal the laminate using a material of a sheet-like barrier layer. Examples thereof also include a method of applying a solution containing a material of the barrier layer dissolved in an organic solvent to the laminate, a method of applying a liquid monomer to be the barrier layer to the laminate and then crosslinking or polymerizing the liquid monomer by heat, UV, or the like, and a method of melting a material of the barrier layer by heat and then cooling the molten material.

Sealing of the laminate using the inorganic material among the materials of the barrier layer is preferably achieved by a vacuum vapor deposition method, a sputtering method, a chemical vapor deposition (CVD) method, or an ion plating method. In particular, in order to form a dense layer, a sputtering method is preferred. A DC magnetron sputtering method is more preferred among sputtering methods.

In the sputtering method, a metal target and oxygen gas or nitrogen gas are used as starting materials and the starting materials are deposited on the laminate to form a film. Thereby, an inorganic layer formed from an inorganic material can be formed.

The material of the barrier layer may be a combination of the thermosetting resin or thermoplastic resin and the inorganic material.

In the solar cell of the first aspect of the present invention, the barrier layer may be further covered with an additional material such as a resin film or a resin film covered with an inorganic material. In other words, the solar cell of the first aspect of the present invention may have a structure in which sealing, filling, or bonding between the laminate and the additional material may be attained by the barrier layer. Thereby, water vapor can be sufficiently blocked even if a pinhole is present in the barrier layer, further improving the durability of the solar cell.

The present invention also encompasses a method for producing a solar cell including: forming a hard film on a flexible substrate; forming an electrode on the hard film and scribing the electrode; forming a photoelectric conversion layer on the scribed electrode and scribing the photoelectric conversion layer; and forming a transparent electrode on the scribed photoelectric conversion layer and scribing the transparent electrode, the hard film containing a nitride, carbide, or boride, the nitride, carbide, or boride containing at least one element selected from the group consisting of titanium, zirconium, aluminum, silicon, magnesium, vanadium, chromium, molybdenum, tantalum, and tungsten.

A method of scribing each of the electrode, the photoelectric conversion layer, and the transparent electrode is preferably mechanical patterning using a scribing tool because it is relatively inexpensive. Scribing each of the electrode, the photoelectric conversion layer, and the transparent electrode enables patterning of each of the electrode, the photoelectric conversion layer, and the transparent electrode, forming a plurality of grooves.

From the viewpoint of productivity, the method for producing a solar cell of the present invention is preferably a roll-to-roll system. The roll-to-roll system may be a system of continuously transporting a sample or may be a stepwise delivery system of intermittently transporting a sample. Alternative to the roll-to-roll system, a sheet-to-sheet system may also be used, for example.

Next, the second aspect of the present invention is described. In a perovskite solar cell in which the photoelectric conversion layer contains an organic-inorganic perovskite compound, an electron transport layer is disposed between the cathode and the photoelectric conversion layer. The electron transport layer allows electrons and holes generated by optical excitation to move efficiently without recombination, and thereby plays a role of improving the photoelectric conversion efficiency of the solar cell. In the perovskite solar cell, a metal such as aluminum is used for the electrode in many cases because the material cost thereof is inexpensive and the resistivity is low. However, in the case of a solar cell including a cathode, an electron transport layer, a photoelectric conversion layer, and an anode in the stated order in which the photoelectric conversion layer contains an organic-inorganic perovskite compound and the cathode is an electrode formed from a metal, especially aluminum, the solar cell has high series resistance and fails to achieve sufficient photoelectric conversion efficiency.

The present inventors performed studies for the purpose of improving the photoelectric conversion efficiency of a solar cell. As a result, the present inventors found that halogen atoms or chalcogen atoms diffuse from the organic-inorganic perovskite compound contained in the photoelectric conversion layer to the cathode and deteriorate the cathode, raising the series resistance and reducing the photoelectric conversion efficiency of the solar cell.

The present inventors found that the use of a metal having a relatively low ionization tendency, especially a metal having a lower ionization tendency than titanium, as a cathode can reduce diffusion of halogen atoms or chalcogen atoms from the organic-inorganic perovskite compound contained in the photoelectric conversion layer to the cathode, maintaining the series resistance of the solar cell at a low level and improving the photoelectric conversion efficiency. Thereby, the second aspect of the present invention was completed.

The solar cell of the second aspect of the present invention includes a cathode, an electron transport layer, a photoelectric conversion layer, and an anode in the stated order.

The cathode contains a metal having a lower ionization tendency than titanium.

The use of a metal having a relatively low ionization tendency, especially a metal having a lower ionization tendency than titanium, as the cathode can reduce diffusion of halogen atoms or chalcogen atoms from the organic-inorganic perovskite compound contained in the photoelectric conversion layer to the cathode, maintaining the series resistance of the solar cell at a low level and improving the photoelectric conversion efficiency.

The metal having a lower ionization tendency than titanium may be any one. Specific examples thereof include molybdenum, zirconium, manganese, tantalum, zinc, chromium, iron, cadmium, cobalt, nickel, tin, lead, antimony, bismuth, copper, mercury, silver, palladium, iridium, platinum, and gold. These metals may be used alone or in combination of two or more. In particular, from the viewpoint of processability, one or more metals selected from the group consisting of molybdenum, cobalt, and nickel is preferred. Molybdenum is more preferred because it is less likely to diffuse to the photoelectric conversion layer and corrode the photoelectric conversion layer.

The cathode may have any thickness. The lower limit of the thickness is preferably 10 nm and the upper limit thereof is preferably 1,000 nm. When the thickness is 10 nm or greater, the cathode can sufficiently receive an electron. When the thickness is 1,000 nm or smaller, thermal damage to the substrate in formation of the cathode can be minimized, improving the photoelectric conversion efficiency. The lower limit of the thickness of the cathode is more preferably 30 nm and the upper limit thereof is more preferably 500 nm. The lower limit is still more preferably 50 nm and the upper limit is still more preferably 200 nm.

The solar cell of the second aspect of the present invention preferably further includes a conductive layer below the cathode.

The cathode as used herein means a conductive layer in direct contact with the electron transport layer, and the conductive layer as used herein means a layer in no direct contact with the electron transport layer.

Disposing the conductive layer below the cathode can further reduce the series resistance of the solar cell, improving the photoelectric conversion efficiency.

The conductive layer may be formed from any material, and is preferably formed from aluminum, gold, silver, or copper because they have low resistivity. In particular, aluminum is more preferred because the material cost is inexpensive. These materials may be used alone or in combination of two or more.

The conductive layer may have any thickness. The lower limit of the thickness is preferably 10 nm and the upper limit thereof is preferably 5 mm. When the thickness is 10 nm or greater, the series resistance of the solar cell can be further reduced, improving the photoelectric conversion efficiency. When the thickness is 5 mm or smaller, the material cost can be reduced, inexpensively producing the solar cell. The lower limit of the thickness is more preferably 50 nm and the upper limit thereof is more preferably 1 mm.

The electron transport layer may be formed from any material. Examples of the material include n-type metal oxides, N-type conductive polymers, N-type low-molecular organic semiconductors, alkali metal halides, alkali metals, and surfactants. Specific examples thereof include titanium oxide and tin oxide. The examples also include cyano group-containing polyphenylene vinylene, boron-containing polymers, bathocuproine, bathophenanthroline, (hydroxyquinolinato)aluminum, oxadiazole compounds, benzoimidazole compounds, naphthalenetetracarboxylic acid compounds, perylene derivatives, phosphine oxide compounds, phosphine sulfide compounds, and fluoro group-containing phthalocyanine.

In particular, from the viewpoint of reducing diffusion of halogen atoms or chalcogen atoms from the organic-inorganic perovskite compound contained in the photoelectric conversion layer to the cathode, n-type metal oxides, alkali metal halides, and alkali metals are preferred. The use of these materials can increase the density of the electron transport layer, further reducing diffusion of halogen atoms or chalcogen atoms from the organic-inorganic perovskite compound contained in the photoelectric conversion layer. Further, from the viewpoint of preventing corrosion of the electron transport layer by halogen atoms or chalcogen atoms, an oxide containing a metal having a relatively low ionization tendency (e.g., titanium oxide, tin oxide) is more preferred. The use of these materials can increase the stability of the electron transport layer, improving the durability of the solar cell.

The electron transport layer may consist only of a thin-film electron transport layer (buffer layer). Still, the electron transport layer preferably includes a porous electron transport layer. In particular, when the photoelectric conversion layer is a composite film in which an organic semiconductor or inorganic semiconductor part and an organic-inorganic perovskite compound part are combined, the composite film is preferably formed on a porous electron transport layer because a more complicated composite film (more intricate structure) can be obtained, enhancing the photoelectric conversion efficiency.

The lower limit of the thickness of the electron transport layer is preferably 1 nm and the upper limit thereof is preferably 2,000 nm. When the thickness is 1 nm or greater, holes can be sufficiently blocked. When the thickness is 2,000 nm or smaller, the electron transport layer is less likely to serve as resistance to electron transport, enhancing the photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The photoelectric conversion layer contains an organic-inorganic perovskite compound represented by the formula: R-M-X₃, wherein R represents an organic molecule; M represents a metal atom; and X represents a halogen atom or a chalcogen atom. A solar cell in which the photoelectric conversion layer contains the organic-inorganic perovskite compound is also referred to as an organic-inorganic hybrid solar cell.

The use of the organic-inorganic perovskite compound in the photoelectric conversion layer can improve the photoelectric conversion efficiency of the solar cell.

The specifications of the photoelectric conversion layer are the same as those of the photoelectric conversion layer in the aforementioned solar cell of the first aspect of the present invention.

The anode may be produced from any material, and a conventionally known material may be used. The anode is preferably a patterned electrode.

Examples of the anode material include transparent conductive materials such as indium tin oxide (ITO), SnO₂, aluminum zinc oxide (AZO), indium zinc oxide (IZO), gallium zinc oxide (GZO), and boron zinc oxide (BZO), and transparent conductive polymers. These materials may be used alone or in combination of two or more.

The solar cell of the second aspect of the present invention may include a hole transport layer between the photoelectric conversion layer and the anode.

The specifications of the hole transport layer are the same as those of the hole transport layer in the aforementioned solar cell of the first aspect of the present invention.

The solar cell of the second aspect of the present invention may further include a substrate or the like. The substrate may be any one, and examples thereof include transparent glass substrates made of soda-lime glass, alkali-free glass, or the like, ceramic substrates, plastic substrates, and metal substrates.

In the solar cell of the second aspect of the present invention, a laminate including the cathode, the electron transport layer, the photoelectric conversion layer, and the anode in the stated order as described above may be sealed by a barrier layer.

The specifications of the barrier layer are the same as those of the barrier layer in the aforementioned solar cell of the first aspect of the present invention.

Similar to the case of the solar cell of the first aspect of the present invention described above, in the solar cell of the second aspect of the present invention, the barrier layer may be further covered with an additional material such as a resin film or a resin film covered with an inorganic material.

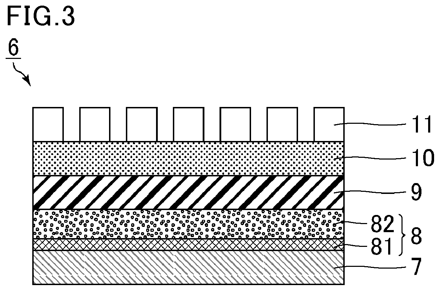

Fig. 3 is a schematic cross-sectional view of an exemplary solar cell of the second aspect of the present invention.

A solar cell 6 illustrated in Fig. 3 includes an electron transport layer 8 (a thin-film electron transport layer 81 and a porous electron transport layer 82), a photoelectric conversion layer 9 containing an organic-inorganic perovskite compound, a hole transport layer 10, and an anode 11 stacked in the stated order on a cathode 7. Although not illustrated, a conductive layer may be disposed below the cathode 7. In the solar cell 6 illustrated in Fig. 3, the anode 11 is a patterned electrode.

The solar cell of the second aspect of the present invention may be produced by any method. An exemplary method includes forming, on the substrate, the conductive layer, the cathode, the electron transport layer, the photoelectric conversion layer, the hole transport layer, and the anode in the stated order.

### - Advantageous Effects of Invention

The present invention can provide a solar cell having excellent photoelectric conversion efficiency and produced through a process including favorable scribing (e.g., mechanical patterning), and a method for producing the solar cell. The present invention can also provide a solar cell having low series resistance and high photoelectric conversion efficiency.

### BRIEF DESCRIPTION OF THE DRAWINGS

Fig. 1 includes schematic cross-sectional views illustrating an exemplary production process for the solar cell of the first aspect of the present invention.
Fig. 2 is a schematic view of an exemplary crystal structure of an organic-inorganic perovskite compound.
Fig. 3 is a schematic cross-sectional view of an exemplary solar cell of the second aspect of the present invention.

### DESCRIPTION OF EMBODIMENTS

Embodiments of the present invention are more specifically described with reference to, but not limited to, the following examples.

### (Example 1)

An aluminum foil (available from UACJ Corp., multipurpose aluminum material A1N30 grade, thickness: 100 µm) was subjected to sulfuric acid anodizing for a treatment duration of 30 minutes, so that an aluminum oxide film (thickness: 5 µm, proportion of thickness: 5%) was formed on a surface of the aluminum foil. Thereby, a flexible substrate was obtained.

A hard film (thickness: 100 nm, Vickers hardness: 2,100 HV) made of titanium nitride (TiN) was formed on the aluminum oxide film using a batch-type sputtering device (available from Ulvac, Inc.) at a RF output of 300 W against a 6-inch Ti target. In this procedure, 20 sccm of Ar and 5 sccm of N₂ were introduced as process gases to control the pressure in film formation to 0.1 Pa.

An Al film having a thickness of 100 nm was formed on the hard film using a vapor deposition device, and then a Ti film having a thickness of 100 nm was formed on the Al film by a sputtering method. Thereby, a cathode (Ti/Al film) was prepared. The Ti/Al film was then patterned (scribing width: 40 µm) by mechanical patterning using a mechanical scribing device (KMPD100, available from Mitsuboshi Diamond Industrial Co., Ltd.).

A titanium oxide paste containing polyisobutyl methacrylate as an organic binder and titanium oxide (mixture of those with an average particle size of 10 nm and those with an average particle size of 30 nm) was applied to the Ti/Al film by a spin coating method, followed by firing at 200°C for 30 minutes. Thereby, a porous electron transport layer with a thickness of 500 nm was formed.

Subsequently, lead iodide as a metal halide compound was dissolved in N,N-dimethylformamide (DMF) to prepare a 1 M solution, and the resulting solution was applied to the porous electron transport layer by a spin coating method to form a film, thereby preparing a sample. Separately, methylammonium iodide as an amine compound was dissolved in 2-propanol to prepare a 1 M solution. The sample with the above lead iodide film was immersed into this solution to form a layer containing CH₃NH₃PbI₃ which is an organic-inorganic perovskite compound. Thereafter, the obtained sample was subjected to annealing treatment at 120°C for 30 minutes.

Next, 68 mM of Spiro-OMeTAD (having a spirobifluorene skeleton), 55 mM of t-butylpyridine, and 9 mM of a bis(trifluoromethylsulfonyl)imide silver salt were dissolved in 25 µL of chlorobenzene to prepare a solution. This solution was applied to the photoelectric conversion layer by a spin coating method. Thereby, a hole transport layer having a thickness of 150 nm was formed.

Subsequently, the layer that is a combination of the electron transport layer, the photoelectric conversion layer, and the hole transport layer was patterned by mechanical patterning.

An ITO film having a thickness of 100 nm was formed as an anode (transparent electrode) on the resulting hole transport layer by a sputtering method. The ITO film was then patterned by mechanical patterning.

A barrier layer having a thickness of 100 nm was formed from ZnSnO by a sputtering method on the resulting anode. Thereby, a solar cell was obtained.

### (Examples 2 to 12)

A solar cell was obtained in the same manner as in Example 1, except that the hard film was changed as shown in Table 1.

### (Comparative Example 1)

A solar cell was obtained in the same manner as in Example 1, except that no hard film was formed.

### (Comparative Example 2)

A solar cell was obtained in the same manner as in Example 1, except that no hard film was formed and the thickness of the aluminum oxide film was changed to 10 µm.

### (Comparative Example 3)

A solar cell was obtained in the same manner as in Example 1, except that the hard film was changed as shown in Table 1.

### <Evaluation 1>

The solar cells obtained in Examples 1 to 12 and Comparative Examples 1 to 3 were evaluated as follows.

### (1) Measurement of photoelectric conversion efficiency

A power source (model 236, available from Keithley Instruments Inc.) was connected between the electrodes of the solar cell, and the photoelectric conversion efficiency was measured with an exposed area of 1 cm² using a solar simulator (available from Yamashita Denso Corp.) at an intensity of 100 mW/cm².

With the photoelectric conversion efficiency of the solar cell obtained in Example 1 being taken as 1.0, the photoelectric conversion efficiency values of the solar cells in Examples 2 to 12 and Comparative Examples 1 to 3 were standardized. The cases where the standardized value was not lower than 0.9 were evaluated as "oo" (Excellent), not lower than 0.7 but lower than 0.9 as "o" (Good), not lower than 0.6 but lower than 0.7 as "Δ" (Acceptable), and lower than 0.6 as "×" (Poor).

**[Table 1]**

| Example 2 | Example 3 | Example 4 | Example 5 | Example 6 | Example 7 | Example 8 | Example 9 | Example 10 | Example 11 | Example 12 | Comparative Example 1 | Comparative Example 2 | Comparative Example 3 |
|---|---|---|---|---|---|---|---|---|---|---|---|---|---|
| Aluminum foil | Aluminum foil | Aluminum foil | Aluminum foil | Aluminum foil | Aluminum foil | Aluminum foil | Aluminum foil | Aluminum foil | Aluminum foil | Aluminum foil | Aluminum foil | Aluminum foil | Aluminum foil |
| Anodic oxide film | Anodic oxide film | Anodic oxide film | Anodic oxide film | Anodic oxide film | Anodic oxide film | Anodic oxide film | Anodic oxide film | Anodic oxide film | Anodic oxide film | Anodic oxide film | Anodic oxide film | Anodic oxide film | Anodic oxide film |
| 5 | 5 | 5 | 5 | 5 | 5 | 5 | 5 | 5 | 5 | 5 | 5 | 10 | 5 |
| TiN | TiN | TiC | TiB₂ | ZrC | ZrN | VC | Mo₂B | WB | Si₃N₄ | AlN | Absent | Absent | Cu |
| 2100 | 2100 | 2800 | 3000 | 2500 | 1600 | 2900 | 2300 | 3100 | 1700 | 1200 | - | - | - |
| 50 | 10 | 50 | 50 | 50 | 100 | 50 | 50 | 50 | 100 | 150 | - | - | 100 |
| ○ | Δ | ○ | ○ | ○ | ○ | ○ | ○ | ○ | ○ | ○ | × | × | × |

### (Example 13)

An aluminum film having a thickness of 200 nm and serving as a conductive layer and a molybdenum film having a thickness of 50 nm and serving as a cathode were formed on a glass substrate in succession by an electron beam deposition method.

Next, titanium oxide was sputtered on a surface of the cathode using a sputtering device (available from Ulvac, Inc.). Thereby, a thin-film electron transport layer having a thickness of 30 nm was formed. Further, a dispersion of titanium oxide (mixture of those with an average particle size of 10 nm and those with an average particle size of 30 nm) in ethanol was applied to the thin-film electron transport layer by a spin coating method, followed by firing at 200°C for 10 minutes. Thereby, a porous electron transport layer having a thickness of 150 nm was formed.

Next, CH₃NH₃I and PbI₂ at a ratio by mole of 1:1 were dissolved in N,N-dimethylformamide (DMF) serving as a solvent such that the total weight concentration of CH₃NH₃I and PbI₂ was adjusted to 20%. Thereby, a solution for forming an organic-inorganic perovskite compound was prepared. This solution was applied to the electron transport layer by a spin coating method, followed by firing at 100°C for 10 minutes. Thereby, a photoelectric conversion layer was formed.

Next, 68 mM of Spiro-OMeTAD (having a spirobifluorene skeleton), 55 mM of t-butylpyridine, and 9 mM of a bis(trifluoromethylsulfonyl)imide silver salt were dissolved in 1 mL of chlorobenzene to prepare a solution. This solution was applied to the photoelectric conversion layer by a spin coating method. Thereby, a hole transport layer having a thickness of 150 nm was formed.

An ITO film having a thickness of 200 nm was formed as an anode on the resulting hole transport layer by sputtering using a sputtering device (available from Ulvac, Inc.). Thereby, a solar cell with the conductive layer, the cathode, the electron transport layer, the photoelectric conversion layer, the hole transport layer, and the anode being stacked therein was obtained.

### (Examples 14 to 22)

A solar cell with a conductive layer, a cathode, an electron transport layer, a photoelectric conversion layer, a hole transport layer, and an anode being stacked therein was obtained in the same manner as in Example 13, except that the type of the conductive layer, the type of the cathode, the thickness of the cathode, and the type of the electron transport layer were changed as shown in Table 2.

### (Comparative Example 4)

A solar cell with a cathode, an electron transport layer, a photoelectric conversion layer, a hole transport layer, and an anode being stacked therein was obtained in the same manner as in Example 13, except that no conductive layer was formed and an aluminum film (having a higher ionization tendency than titanium) was formed as the cathode.

### (Comparative Examples 5 and 6)

A solar cell with a conductive layer, a cathode, an electron transport layer, a photoelectric conversion layer, a hole transport layer, and an anode being stacked therein was obtained in the same manner as in Example 13, except that the type of the cathode was changed as shown in Table 2.

### <Evaluation 2>

The solar cells obtained in Examples 13 to 22 and Comparative Examples 4 to 6 were evaluated as follows. Evaluation results are shown in Table 2.

### (1) Measurement of photoelectric conversion efficiency

A power source (model 236, available from Keithley Instruments Inc.) was connected between the electrodes of the solar cell. A current-voltage curve was drawn using a solar simulator (available from Yamashita Denso Corp.) at an intensity of 100 mW/cm², and the photoelectric conversion efficiency was calculated. The cases where the photoelectric conversion efficiency was not lower than 10% were evaluated as ○○ (Excellent), not lower than 8% but lower than 10% as ○ (Good), and lower than 8% as × (Poor).

### (2) Calculation of series resistance

In the current-voltage curve drawn in the Measurement (1), the reciprocal of the slope at the point of intersection of the curve with the X axis was calculated as the series resistance. The cases where the series resistance was lower than 5 Ω were evaluated as oo (Excellent), not lower than 5 Ω but lower than 10 Ω as ○ (Good), and not lower than 10 Ω as × (Poor).

**[Table 2]**

| | Conductive layer | Cathode | Thickness of cathode (nm) | Electron transport layer | Evaluation | |
|---|---|---|---|---|---|---|
| | | | | | Photoelectric conversion efficiency | Series resistance |
| Example 13 | Aluminum | Molybdenum | 50 | Titanium oxide | ○○ | ○○ |
| Example 14 | Aluminum | Cobalt | 50 | Titanium oxide | ○ | ○○ |
| Example 15 | Aluminum | Nickel | 50 | Titanium oxide | ○ | ○○ |
| Example 16 | Aluminum | Molybdenum | 20 | Titanium oxide | ○○ | ○○ |
| Example 17 | Aluminum | Molybdenum | 10 | Titanium oxide | ○ | ○ |
| Example 18 | Copper | Molybdenum | 50 | Titanium oxide | ○ | ○ |
| Example 19 | Absent | Molybdenum | 100 | Titanium oxide | ○ | ○ |
| Example 20 | Aluminum | Tantalum | 50 | Titanium oxide | ○ | ○ |
| Example 21 | Aluminum | Molybdenum | 50 | Tin oxide | ○ | ○ |
| Example 22 | Aluminum | Molybdenum | 50 | PCBM | ○ | ○ |
| Comparative Example 4 | Absent | Aluminum | 100 | Titanium oxide | × | × |
| Comparative Example 5 | Aluminum | Magnesium | 50 | Titanium oxide | × | × |
| Comparative Example 6 | Aluminum | Titanium | 50 | Titanium oxide | × | × |

### INDUSTRIAL APPLICABILITY

The present invention can provide a solar cell having excellent photoelectric conversion efficiency and produced through a process including favorable scribing (e.g., mechanical patterning), and a method for producing the solar cell. The present invention can also provide a solar cell having low series resistance and high photoelectric conversion efficiency.

### REFERENCE SIGNS LIST

1: Metal foil
2: Insulating layer
3: Hard film
4: Electrode
41: Groove
5: Scribing tool
6: Solar cell
7: Cathode
8: Electron transport layer
81: Thin-film electron transport layer
82: Porous electron transport layer
9: Photoelectric conversion layer containing organic-inorganic perovskite compound
10: Hole transport layer
11: Anode (patterned electrode)

## Claims

1. A solar cell comprising, above a flexible substrate:
an electrode;
a transparent electrode; and
a photoelectric conversion layer disposed between the electrode and the transparent electrode,
the solar cell further comprising a hard film disposed between the flexible substrate and the electrode,
the hard film containing a nitride, carbide, or boride, the nitride, carbide, or boride containing at least one element selected from the group consisting of titanium, zirconium, aluminum, silicon, magnesium, vanadium, chromium, molybdenum, tantalum, and tungsten.

2. The solar cell according to claim 1,
wherein the hard film has a Vickers hardness of 500 to 3,500 HV.

3. The solar cell according to claim 1 or 2,
wherein the flexible substrate includes a metal foil and an insulating layer formed on the metal foil.

4. The solar cell according to claim 3,
wherein the metal foil is an aluminum foil and the insulating layer is an aluminum oxide film.

5. The solar cell according to claim 4,
wherein the aluminum oxide film is an anodic oxide film.

6. The solar cell according to claim 1, 2, 3, 4, or 5,
wherein the photoelectric conversion layer contains an organic-inorganic perovskite compound represented by the formula: R-M-X₃, wherein R represents an organic molecule; M represents a metal atom; and X represents a halogen atom or a chalcogen atom.

7. A method for producing a solar cell, comprising:
forming a hard film on a flexible substrate;
forming an electrode on the hard film and scribing the electrode;
forming a photoelectric conversion layer on the scribed electrode and scribing the photoelectric conversion layer; and
forming a transparent electrode on the scribed photoelectric conversion layer and scribing the transparent electrode,
the hard film containing a nitride, carbide, or boride, the nitride, carbide, or boride containing at least one element selected from the group consisting of titanium, zirconium, aluminum, silicon, magnesium, vanadium, chromium, molybdenum, tantalum, and tungsten.

8. A solar cell comprising, in the stated order:
a cathode;
an electron transport layer;
a photoelectric conversion layer; and
an anode,
the photoelectric conversion layer containing an organic-inorganic perovskite compound represented by the formula: R-M-X₃, wherein R represents an organic molecule; M represents a metal atom; and X represents a halogen atom or a chalcogen atom,
the cathode containing a metal having a lower ionization tendency than titanium.

9. The solar cell according to claim 8,
wherein the metal having a lower ionization tendency than titanium includes one or more metals selected from the group consisting of molybdenum, cobalt, and nickel.

10. The solar cell according to claim 9,
wherein the metal having a lower ionization tendency than titanium is molybdenum.

11. The solar cell according to claim 8, 9, or 10, further comprising a conductive layer below the cathode.
